**Europäisches Patentamt**

**European Patent Office**

**Office européen des brevets**

(11) Veröffentlichungsnummer: **0 278 516**
**A2**

(12) **EUROPÄISCHE PATENTANMELDUNG**

(21) Anmeldenummer: **88102063.0**

(22) Anmeldetag: **12.02.88**

(51) Int. Cl.⁴: **B65G 47/91 , H01L 21/00**

(30) Priorität: **13.02.87 DE 3704505**

(43) Veröffentlichungstag der Anmeldung:
**17.08.88 Patentblatt 88/33**

(84) Benannte Vertragsstaaten:
**AT BE CH DE FR GB IT LI NL SE**

(71) Anmelder: **LEYBOLD AKTIENGESELLSCHAFT**
**Wilhelm-Rohn-Strasse 25**
**D-6450 Hanau 1(DE)**

(72) Erfinder: **Helms, Dirk, Dr.**
**Kurt-Nonne-Weg 2**
**D-2070 Ahrensburg(DE)**

(74) Vertreter: **Zapfe, Hans, Dipl.-Ing.**
**Seestrasse 2 Postfach 30 04 08**
**D-6054 Rodgau-3(DE)**

(54) **Einlegegerät für Vakuumanlagen.**

(57) Einlegegerät für Vakuumanlagen mit einem zweiteiligen, ein Gelenk aufweisenden Hebelarm, der um eine Hauptachse schwenkbar ist, sowie mit mindestens einem Antriebsmotor für die Bewegung des Hebelarms um die Hauptachse und für die Veränderung der Winkelstellung der inneren und äußeren Teile des Hebelarms im Gelenk. Der Antrieb erfolgt durch eine Hohlwellenanordnung (4, 5), bei der die Hohlwelle (4) drehfest mit dem Antriebsende (6) des Hebelarms (7) und die Mittenwelle (5) mit einem Übertragungsmechanismus für die Veränderung der Winkelstellung verbunden ist. Je ein unabhängig steuerbarer Antriebsmotor (18, 19) ist mit der Hohlwelle (4) einerseits und mit der Mittenwelle (5) andererseits verbunden. Der innere Teil (7a) des Hebelarms ist als gasdichter Hohlkörper ausgebildet, der den Übertragungsmechanismus von der Mittenwelle (5) zum Gelenkzapfen (9) umschließt. Schließlich sind die Lagerstellen der Hohlwelle (4) und des Gelenkzapfens (9) gegenüber dem Innenraum (22) der Vakuumanlage (35) durch mindestens reibungsarme Dichtungselemente (23, 24) abgedichtet.

FIG.1

EP 0 278 516 A2

## " Einlegegerät für Vakuumanlagen "

Die Erfindung betrifft ein Einlegegerät für Vakuumanlagen mit einem zweiteiligen, ein Antriebsende, ein Gelenk und ein Halteende für ein Objekt aufweisenden Hebelarm, der in mindestens einer waagrechten Ebene um eine senkrechte, im Bereich des Antriebsendes angeordnete Hauptachse - schwenkbar ist, sowie mit mindestens einem Antriebsmotor für die Bewegung des Hebelarms um die Hauptachse und für die Veränderung der Winkelstellung der Teile des Hebelarms im Gelenk.

Durch eine Firmendruckschrift der Firma Brooks Automation in North Billerica, Mass./USA ist ein Einlegegerät der vorstehend beschriebenen Gattung bekannt, bei dem auf einer drehbaren Plattform mit einer Hauptachse in spiegelsymmetrischer Anordnung zwei zweiteilige Hebelarme angeordnet sind, die an ihren äußeren Enden gelenkig mit einer Tragplatte für den Transport von Wafern verbunden sind. Die Antriebsenden der beiden Hebelarme sind über je eine Welle in der Plattform gelagert, wobei die beiden Wellen einen Abstand voneinander haben. Grob gesehen bilden die beiden zweiteiligen Hebel ein Parallelogramm, das auch als Abschnitt eines Scherengetriebes aufgefaßt werden kann. Durch entsprechende Steuerung und Überlagerung von Radial-und Tangentialbewegungen läßt sich mit der bekannten Lösung eine kreisringförmige Fläche bestreichen, wobei bei einer Schwenkbewegung des Systems allerdings jedes-mal die gesamte Masse beschleunigt und verzögert werden muß. Außerdem besitzt das System eine Vielzahl von Gelenk-und Lagerstellen, die innerhalb des Vakuums angeordnet und daher - schlecht zu schmieren sind. Dadurch und durch die Vielzahl der Gelenk-und Lagerstellen tritt unvermeidbar ein Abrieb auf, der für zahlreiche Produktionsprozesse ein äußerst störender Faktor ist.

Durch die DE-OS 24 02 026 ist ein Linear-Kurbelantrieb bekannt, bei dem die beiden gleich langen Teile eines zweiteiligen Hebelarms im Übersetzungsverhältnis 2:1 durch einen gemeinsamen Antrieb angetrieben werden, so daß ein Kraftangriffspunkt "P" am freien Ende des Hebelarms eine jeweils geradlinige Bewegung ausführt. Durch eine Verschwenkung des gesamten Systems ist es möglich, sämtliche Punkte innerhalb einer Kreisringfläche anzusteuern. Durch die Zwangskopplung der beiden Teile des einzigen Hebelarms ist es jedoch nicht möglich, gegebenenfalls mit beiden Teilen des Hebelarms voneinander unabhängige Bewegungen auszuführen. Wird ein solcher Linearantrieb im Vakuum angeordnet, wofür er vorgesehen ist, so ist die Mehrzahl aller Gelenkstellen einschließlich der Getriebeteile für die Zwangskorrelierung der Bewegungen im Vakuum angeordnet.

Zwar werden hierbei Schiebebewegungen vermieden, jedoch finden Abwälzbewegungen statt, so daß ein solches System nicht in Vakuumanlagen verwendet werden kann, die beispielhaft für die Herstellung von integrierten Halbleiterschaltungen dienen.

Im Rahmen der Herstellung integrierter Halbleiterschaltungen werden Wafer in einem mehrstufigen Prozeß (Metallisierung, Ätzen, Oxidation) im Vakuum bearbeitet. Dazu durchlaufen die Wafer nacheinander mehrere Prozeßkammern, in denen die eigentliche Bearbeitung stattfindet. Einen wesentlichen Störfaktor in diesem Fertigungsprozeß stellen Staubpartikel dar, die sich auf dem Wafer absetzen und dann zu Fehlern in den Schaltkreisen führen. Die Einbringung von Staubteilchen von außen und ihre Erzeugung im Innern der Anlage muß daher soweit wie möglich vermieden werden. Staub im Innern der Anlage bildet sich durch Oberflächenabrieb bewegter Teile, da eine zuverlässige Schmierung im Vakuum praktisch nicht möglich ist. Mitentscheidend für den Erfolg einer derartigen Anlage ist daher ein Transportmechanismus für Wafer, der mit möglichst wenig verschleißbehafteten Komponenten auskommt. Erschwert wird diese Forderung noch durch die üblichen Arbeitstemperaturen von etwa 250 bis 300 °C.

Weiterhin ist eine möglichst erschütterungsfreie Transportbewegung der Wafer wünschenswert, da diese, insbesondere bei Abmessungen von 200 mm und darüber, sehr zerbrechlich sind. Auch an die Zuverlässigkeit und damit Einfachheit des Transportmechanismus werden hohe Anforderungen gestellt, die allenfalls einen Fehler auf etwa 10000 Bewegungsvorgänge zulassen. Da die Waferbearbeitungsanlagen in Reinsträumen aufgestellt werden, ist außerdem auf geringen Platzbedarf zu achten, da die Erstellungs-und Betriebskosten pro Flächeneinheit der Aufstellfläche sehr hoch sind. Die Hauptforderung an eine Mehrkammeranlage zur Waferbearbeitung sind daher neben dem Bearbeitungsprozeß selbst die Betriebssicherheit, Partikelfreiheit und geringer Platzbedarf der Teile der mechanischen Transporteinrichtung.

Der Erfindung liegt daher die Aufgabe zugrunde, ein Einlegegerät der eingangs beschriebenen Gattung anzugeben, mit dem empfindliche Objekte auf-einfache, sichere und kontaminationsfreie Weise zwischen den verschiedenen Stationen - einer Vakuumanlage transportiert werden können.

Stationen in diesem Sinne sind die Proezßkammern selbst, in denen zum Beispiel Prozesse wie Plasma-Ätzen, Oxidieren und Metallisieren ausgeführt werden, sowie die Be-und Entladestationen der Anlage. Letztere sind meist in Form von Kassettenein-und -ausgabestationen ausgeführt.

Die Lösung der gestellten Aufgabe erfolgt bei dem eingangs beschriebenen Einlegegerät erfindungsgemäß dadurch, daß

a) die Hauptachse von einem Gehäuse umgeben ist, in dem drehbar eine äußere Hohlwelle und koaxial hierzu eine Mittenwelle angeordnet sind, wobei die äußere Hohlwelle drehfest mit dem Antriebsende des Hebelarms und die Mittenwelle mit einem Übertragungsmechanismus verbunden ist, der auf einen zum Gelenk gehörenden drehbaren Gelenkzapfen einwirkt, der den äußeren Teil des Hebelarms mit dem Halteende trägt,

b) je ein unabhängig steuerbarer Antriebsmotor mit der Hohlwelle einerseits und mit der Mittenwelle andererseits verbunden ist,

c) der innere Teil des Hebelarms als gasdichter Hohlkörper ausgebildet ist, der den Übertragungsmechanismus von der Mittenwelle zum Gelenkzapfen umschließt, und daß

d) die Lagerstellen der Hohlwelle und des Gelenkzapfens gegenüber dem Innenraum der Vakuumanlage durch mindestens reibungsarme, vorzugsweise durch reibungsfreie, Dichtungselemente abgedichtet sind.

Durch die erfindungsgemäße Lösung wird nicht nur die Zahl der Reibungsstellen des Antriebssystems drastisch verringert, sondern auch die noch vorhandenen Reibungsstellen werden an Orten untergebracht, die außerhalb des Vakuums liegen und damit auch geschmiert werden können. Damit wird eine sehr viel bessere und über eine lange Betriebsdauer beständige Führung der einzelnen bewegten Teile relativ zueinander erreicht, so daß ein sehr weitgehend erschütterungsfreier Transport der zu behandelnden Objekte möglich ist. Der Erfindungsgegenstand ist frei von jedem Partikelabrieb, der in die Vakuumanlage eindringen könnte.

Durch eine präzise Steuerung der voneinander unabhängigen Antriebsmotoren, beispielsweise durch einen Mikroprozessor, läßt sich ein sehr genauer Bewegungsablauf des Halteendes des äußeren Teils des Hebelarms erreichen, so daß sämtliche Punkte innerhalb einer Kreisringfläche auf den jeweils günstigsten Bewegungsbahnen angefahren werden können. Da für den Antrieb Servomotoren mit Tachogeneratoren und Positionsgebern verwendet werden, können handelsübliche Steuerungen verwendet werden, wie sie für Industrie-Roboter und/oder Werkzeugmaschinen üblich sind.

An die Stelle der erwähnten Servomotoren können auch Torque-Motoren eingesetzt werden, die unmittelbar auf die koaxialen Hohlwellen bzw.

die Mittenwelle einwirken, wodurch die Zahnradübersetzungen entfallen können.

Die Lehre, daß die Lagerstellen der Hohlwelle und des Gelenkzapfens oegenüber dem Innenraum der Vakuumanlage durch mindestens reibungsarme Dichtungselemente abgedichtet sind, schließt die Lehre der Verwendung reibungsfreier Dichtungselemente ein. Reibungsarme Dichtungselemente sind beispielsweise in Form von Dichtungsringen aus elastomeren Werkstoffen auf dem Markt. Ein reibungsfreies Dichtungssystem ist beispielhaft durch das Prinzip der "Ferrofluid-Dichtungen" bekannt.

Es ist dabei besonders vorteilhaft, wenn das Gehäuse für die konzentrischen Wellen vakuumdicht mit einer Wand der Vakuumanlage verbunden ist, was entweder starr durch einen Dichtflansch oder flexibel bzw. axial verschiebbar über einen Kompensator erfolgen kann. Mit besonderem Vorteil wird als Kompensator ein sogenannter Faltenbalg verwendet, der je nach Bauweise einen beträchtlichen axialen Verschiebeweg zuläßt, ohne daß hierbei Abrieb auftritt. Mit besonderem Vorteil liegt das Gehäuse dabei außerhalb des Vakuumraums der Vakuumanlage.

Weitere vorteilhafte Ausgestaltungen des Erfindungsgegenstandes ergeben sich aus den übrigen Unteransprüchen.

Ein Ausführungsbeispiel des Erfindungsgegenstandes und seine Einsatzmöglichkeit werden nachfolgend anhand der Figuren 1 bis 6 näher erläutert.

Es zeigen:

Figur 1 einen Axialschnitt entlang der Hauptachse durch ein vollständiges Einlegegerät,

Figur 2 eine Draufsicht auf den Gegenstand von Figur 1,

Figur 3 einen Axialschnitt entlang der Linie III-III durch den Gegenstand von Figur 4,

Figur 4 einen Querschnitt durch den Gegenstand von Figur 3 entlang der Linie IV-IV,

Figur 5 einen teilweisen Schnitt entlang der Linie V-V in Figur 4 und

Figur 6 eine Draufsicht auf ein Einlegegerät analog Figur 2, jedoch in verkleinertem Maßstab und im Zusammenwirken mit einer Vakuumanlage mit mehreren Stationen.

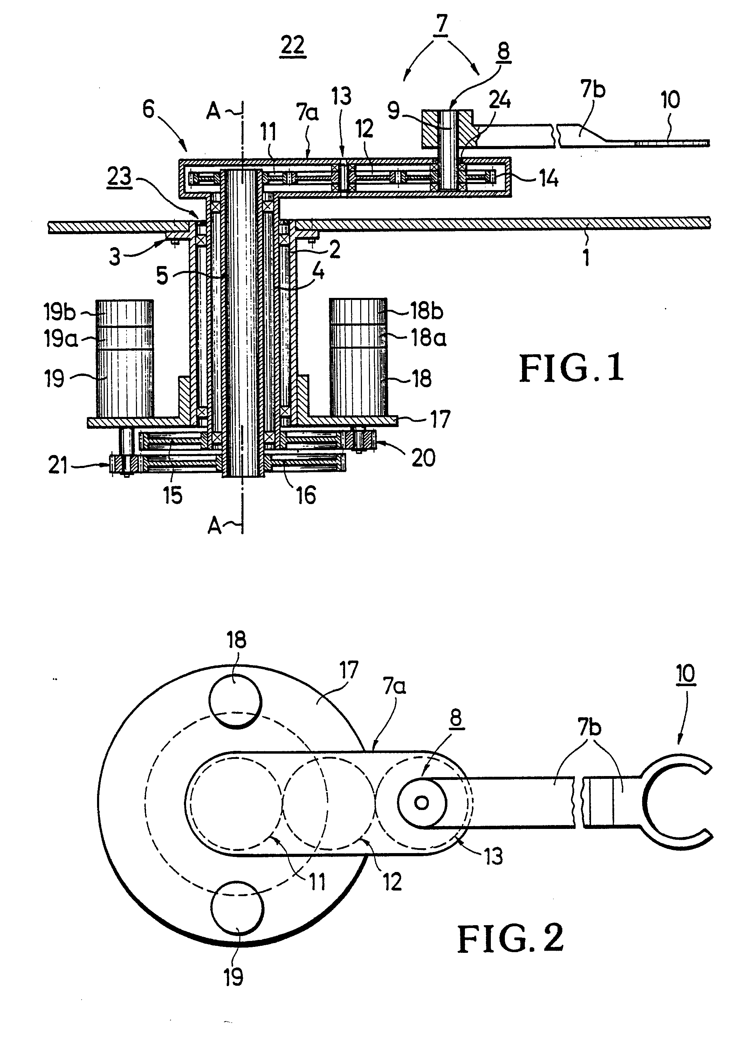

In Figur 1 ist eine Wand 1 dargestellt, die beispielsweise die Bodenplatte einer Vakuumanlage ist, wobei die Vakuumseite oberhalb der Wand 1 liegt. In dieser Wand ist ein Gehäuse 2 vakuumdicht mittels eines Flansches 3 befestigt. In dem Gehäuse 2 ist mittels nicht näher bezeichneter Wälzlager zunächst eine äußere Hohlwelle 4 und koaxial hierzu eine innere Mittenwelle 5 gelagert. Hohlwelle 4 und Mittenwelle 5 definieren eine Hauptachse A-A. Die Mittenwelle 5 kann wahlweise als Hohlwelle oder als Massivwelle ausgeführt sein.

Die äußere Hohlwelle 4 ist verdrehfest mit dem Antriebsende 6 eines zweiteiligen Hebelarms 7 verbunden. Dieser Hebelarm besteht aus einem inneren Teil 7a und einem äußeren Teil 7b, die durch ein Gelenk 8 miteinander verbunden sind. Zum Gelenk 8 gehört ein Gelenkzapfen 9, der drehfest im äußeren Hebelteil 7b, aber drehbar im inneren Hebelteil 7a gelagert ist. Auf diese Weise kann der Hebelteil 7b Drehbewegungen um die Hauptachse A-A und (überlagerte) Drehbewegungen um das Gelenk 8 ausführen. Das freie Ende des Hebelteils 7b bildet ein sogenanntes Halteelement für ein Objekt, beispielsweise einen Wafer. Das Halteende 10 wird durch einen Ausschnitt aus einem Kreisring gebildet, wie dies insbesondere aus Figur 2 hervorgeht.

Wie aus Figur 1 hervorgeht, ist der innere Hebelteil 7a als gasdichter Hohlkörper ausgebildet, der einen Über tragungsmechanismus aufnimmt, der die Verbindung von der Mittenwelle 5 zum Gelenkzapfen 9 bildet. Zu diesem Zweck endet die Mittenwelle 5 im Hohlraum des Hebelteils 7a und ist dort verdrehfest mit einem ersten Zahnrad 11 versehen. Dieses Zahnrad kämmt mit einem zweiten Zahnrad 12, das auf einer Blindwelle 13 innerhalb des Hebelteils 7a gelagert ist. Das zweite Zahnrad 12 kämmt wiederum mit einem dritten Zahnrad 14, das verdrehfest mit dem Gelenkzapfen 9 verbunden ist. Auf diese Weise überträgt sich eine Drehbewegung der Mittenwelle 5 gleichsinnig auf den Gelenkzapfen 9 und damit auf den äußeren Hebelteil 7b. Das System von Zahnrädern 11, 12 und 14 kann auch durch einen Ketten-oder Riementrieb ersetzt werden.

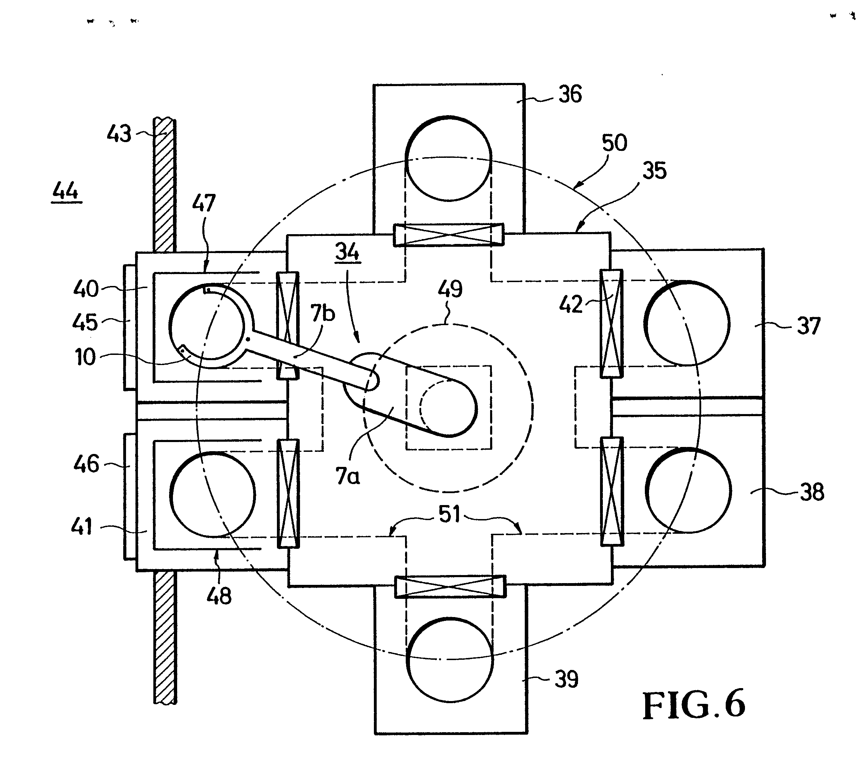

Die Hohlwelle 4 ist an ihrem unteren Ende mit einem weiteren Zahnrad 15 versehen, während das untere Ende der Mittenwelle 5 ein weiteres Zahnrad 16 trägt, wobei die Verbindung jeweils drehfest ist und die Zahnräder 15 und 16 achsgleich angeordnet sind. Am unteren Ende des Gehäuses 2 ist ein Tragflansch 17 angeordnet, auf dem zwei Antriebsmotoren 18 und 19 mit Tachogeneratoren 18a bzw. 19a und Weggebern 18b bzw. 19b befestigt sind. Der Antriebsmotor 18 treibt ein Ritzel 20, das mit dem Zahnrad 15 kämmt, während der Antriebsmotor 19 ein Ritzel 21 antreibt, das mit dem Zahnrad 16 kämmt. Es ergibt sich, daß auf diese Weise durch jeweils unabhängige Steuerung der Antriebsmotoren 18 und 19 mit dem Halteende 10 jeder Punkt innerhalb einer Kreisringfläche angesteuert werden kann, was nachstehend anhand der Figur 6 noch näher erläutert werden wird. Es ist dabei wesentlich, daß das Antriebssystem, bestehend aus den Antriebsmotoren 18 und 19, den zugehörigen Tachogeneratoren und Weggebern, außerhalb der Vakuumkammer, d.h. unter der Wand 1 angeordnet ist.

Die Lagerstellen der Hohlwellen 5 gegenüber dem Gehäuse 2 einerseits und des Gelenkzapfens 9 gegenüber dem inneren Hebelteil 7a andererseits sind in Richtung auf den Innenraum 22 der Vakuumanlage durch Dichtungselemente 23 und 24 abgedichtet, die als "Ferrofluid"-Dichtungen ausgeführt sind und reibungsarm bzw. reibungsfrei sind.

In Figur 2 sind gleiche Teile wie in Figur 1 mit gleichen Bezugszeichen versehen. Lediglich die Antriebsmotoren 18 und 19 sind in einer räumlich verdrehten Lage dargestellt, was jedoch an dem Funktionsprinzip nichts ändert.

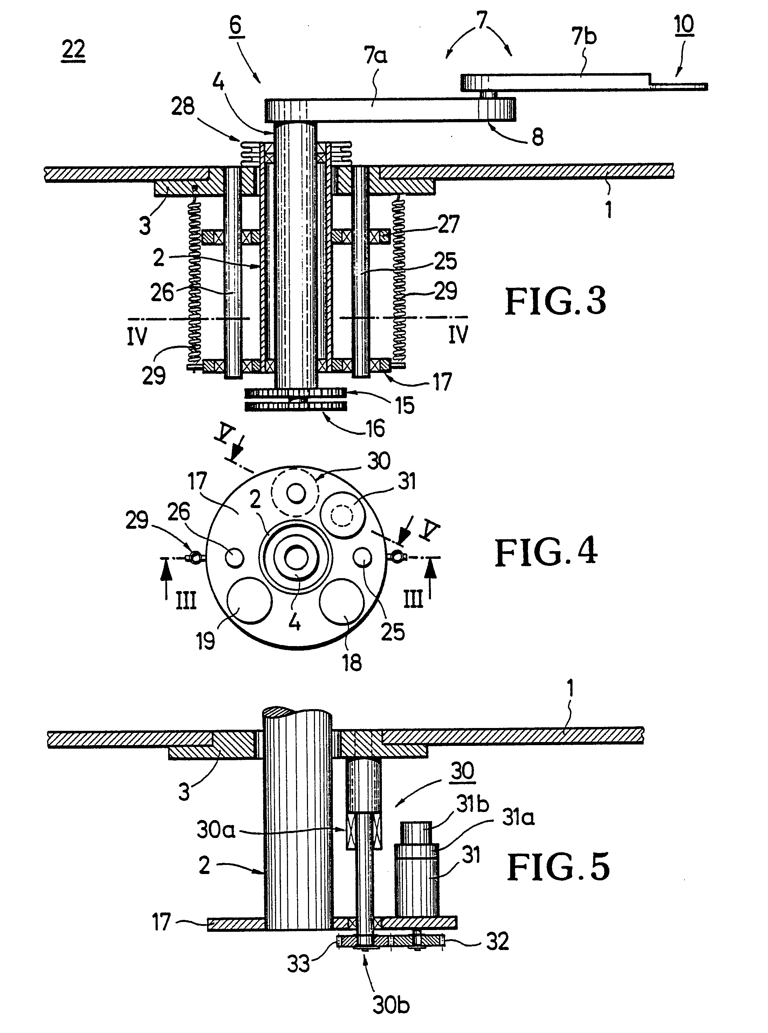

In den Figuren 3 bis 5 sind Teile mit gleicher oder analoger Funktion wie in den Figuren 1 und 2 mit gleichen Bezugszeichen versehen. Gegenüber dem Gegenstand nach den Figuren 1 und 2 liegen lediglich folgende Ergänzungen vor:

Das Gehäuse 2 ist achsparallel verschiebbar an zur Hauptachse A-A parallelen Führungssäulen 25 und 26 geführt, und zwar durch hier nicht näher bezeichnete Kugelbuchsen, von denen ein Paar im Tragflansch 17 und ein weiteres Paar in einem Führungsflansch 27 angeordnet ist. Um hierbei die erforderliche Vakuumdichtheit zu gewährleisten, ist das obere Ende des Gehäuses 2 über einen als Faltenbalg ausgeführten Kompensator 28 gasdicht mit dem Flansch 3 verbunden, der seinerseits wiederum gasdicht in die Wand 1 der Vakuumkammer eingesetzt ist. Durch Verschiebung des Gehäuses 2 in Richtung der Hauptachse A-A läßt sich erreichen, daß der Hebelarm 7 nicht nur in einer Ebene, sondern in einer Vielzahl von Ebenen verschwenkt werden kann. Auf diese Weise läßt sich nicht nur eine genaue Justierung des Einlegegeräts erreichen, sondern auch ein Ansteuern bestimmter Ebenen, die beispielsweise durch die Einschuböffnungen in den Kassetten oder Magazinen vorgegeben werden. Federelemente 29 dienen zur Gewichtskompensation, um den Antrieb für die Linearbewegung zu entlasten.

Zur Herbeiführung dieser Linearbewegung ist ein Spindeltrieb 30 mit einem weiteren Antriebsmotor 31 vorgesehen, zu dem in gleicher Weise ein Tachogenerator 31a und ein Weggeber 31b gehören. Der Spindeltrieb 30 besteht aus einer Spindelmutter 30a, die als Kugelumlauf-Büchse ausgeführt ist, sowie aus einer Gewindespindel 30b. Der Antrieb erfolgt durch ein Räderpaar 32 bzw. 33. Die Führungssäulen 25 und 26 sind ebenso wie die Spindelmutter 30a an dem Flansch 3 befestigt.

Insbesondere der in Figur 4 dargestellte Querschnitt macht deutlich, wo die Antriebsmotoren 18, 19 und 31, die Führungssäulen 25 und 26 und die Federelemente 29 auf bzw. an dem unteren Tragflansch 17 befestigt sind. In Figur 5 sind die Antriebsmotoren 18 und 19 sowie die Wellen 4 und 5 mit ihren Zahnrädern 15 und 16 und die damit kämmenden Ritzel 20 und 21 der Einfachheit halber fortgelassen. Auch Figur 3 zeigt von den Wellen 4 und 5 nur die Zahnräder 15 und 16. Aufbau und Wirkungsweise stimmen jedoch mit der Darstellung in Figur 1 überein.

Figur 6 zeigt ein Einlegegerät 34 nach den Figuren 1 und 2 im Einsatz in einer Vakuumkammer 35, der auf dem Umfang verteilt vier Prozeßkammern 36, 37. 38 und 39 zugeordnet sind, desgleichen eine Kassettenstation 40 für die Zufuhr unbehandelter Substrate und eine Kassettenstation 41 für die Aufnahme behandelter Substrate. Prozeßkammern und Kassettenstationen sind gleichfalls evakuierbar und stehen über Schleusenventile 42 mit der Vakuumkammer 35 in Verbindung. Die Kassettenstationen 40 und 41 durchdringen eine Trennwand 43, auf deren linker Seite sich der sogenannte Sauberraum 44 befindet. In diesen Sauberraum münden die Kassettenstationen 40 und 41 mittels zweier weiterer Schleusenventile 45 und 46, durch die hindurch die Kassettenstationen mit Kassetten bzw. Magazinen 47 bzw. 48 beschickt werden können.

Die Bewegungsbahnen des Halteendes 10 verlaufen innerhalb einer Kreisringfläche, die durch die konzentrischen Kreise 49 und 50 begrenzt wird. Es ist zu erkennen, daß dadurch die Bewegungsbahnen des Halteendes 10 bis in die Prozeßkammern bzw. in die Kassettenstationen hineinreichen, um dort Substrate aufnehmen bzw. ablegen zu können. In besonders zweckmäßiger Weise wird eine Hüllkurve für die Bewegung des Halteendes 10 durch den gestrichelten polygonalen Kurvenzug 51 begrenzt. In besonders zweckmäßiger Weise besitzen die Kassettenstationen je eine Hubvorrichtung, mit der das betreffende Substrat in eine Höhenlage gebracht werden kann, in der es von dem Halteende aufgenommen werden kann.

**Ansprüche**

1. Einlegegerät für Vakuumanlagen mit einem zweiteiligen, ein Antriebsende, ein Gelenk und ein Halteende für ein Objekt aufweisenden Hebelarm, der in mindestens einer waagrechten Ebene um eine senkrechte, im Bereich des Antriebsendes angeordnete Hauptachse schwenkbar ist, sowie mit mindestens einem Antriebsmotor für die Bewegung des Hebelarms um die Hauptachse und für die Veränderung der Winkelstellung der Teile des Hebelarms im Gelenk, dadurch gekennzeichnet, daß

a) die Hauptachse A-A von einem Gehäuse (2) umgeben ist, in dem drehbar eine äußere Hohlwelle (4) und koaxial hierzu eine Mittenwelle (5) angeordnet sind, wobei die äußere Hohlwelle (4) drehfest mit dem Antriebsende (6) des Hebelarms (7) und die Mittenwelle (5) mit einem Übertragungsmechanismus verbunden ist, der auf einen zum Gelenk (8) gehörenden drehbaren Gelenkzapfen (9) einwirkt, der den äußeren Teil (7b) des Hebelarms (7) mit dem Halteende (10) trägt,

b) je ein unabhängig steuerbarer Antriebsmotor mit der Hohlwelle (4) einerseits und mit der Mittenwelle (5) andererseits verbunden ist,

c) der innere Teil (7a) des Hebelarms als gasdichter Hohlkörper ausgebildet ist, der den Übertragungsmechanismus von der Mittenwelle (5) zum Gelenkzapfen (9) umschließt und daß

d) die Lagerstellen der Hohlwelle (4) und des Gelenkzapfens (9) gegenüber dem Innenraum (22) der Vakuumanlage (35) durch mindestens reibungsarme Dichtungselemente (23, 24) abgedichtet sind.

2. Einlegegerät nach Anspruch 1, dadurch gekennzeichnet, daß das Gehäuse (2) vakuumdicht mit einer Wand (1) der Vakuumanlage (35) verbunden ist.

3. Einlegegerät nach Anspruch 2, dadurch gekennzeichnet, daß Hohlwelle (4) und Mittenwelle (5) mit je einem achsgleichen Zahnrad (15, 16) versehen und die Antriebsmotoren (18, 19) am Gehäuse (2) befestigt sind, wobei je ein Antriebsmotor über ein Ritzel (20, 21) mit dem jeweiligen Zahnrad (15, 16) kämmt.

4. Einlegegerät nach Anspruch 3, dadurch gekennzeichnet, daß das Gehäuse (2) mit einem Tragflansch (17) versehen ist, an dem die Antriebsmotoren (18, 19) befestigt sind.

5. Einlegegerät nach Anspruch 2, dadurch gekennzeichnet, daß das Gehäuse ( 2) achsparallel verschiebbar an zur Hauptachse A-A parallelen Führungssäulen (25, 26) geführt und über einen Kompensator (28) gasdicht mit einer Wand (1 ) der Vakuumanlage (35) verbunden ist.

6. Einlegegerät nach Anspruch 5. dadurch gekennzeichnet, daß zur Herbeiführung einer Verschiebung des Gehäuses ( 2) ein Spindeltrieb (30) mit einem weiteren Antriebsmotor (31) vorgesehen ist.

7. Einlegegerät nach den Ansprüchen 4 und 6, dadurch gekennzeichnet, daß der weitere Antriebsmotor (31) am Tragflansch (17) befestigt ist.

FIG.1

FIG.2

**FIG.3**

**FIG.4**

**FIG.5**

FIG.6